# FASCICULE DE BREVET EUROPEEN

(11) **EP 4 350 721 B1**
(45) Date de publication et mention de la délivrance du brevet: **25.06.2025**
(21) Numéro de dépôt: 23198161.4
(22) Date de dépôt: 19.09.2023
(51) Int. Cl.: H01F 27/02, H01F 38/30, G01R 15/18, G01R 15/20

(54) **CAPTEUR MAGNÉTIQUE DE COURANT, CAPTEUR DE COURANT MIXTE COMPORTANT UN TEL CAPTEUR MAGNÉTIQUE DE COURANT, ET DISJONCTEUR COMPORTANT UN TEL CAPTEUR DE COURANT MIXTE**
MAGNETISCHER STROMSENSOR, MISCHSTROMSENSOR MIT EINEM SOLCHEN MAGNETISCHEN STROMSENSOR UND SCHUTZSCHALTER MIT EINEM SOLCHEN MISCHSTROMSENSOR
MAGNETIC CURRENT SENSOR, MIXED CURRENT SENSOR COMPRISING SUCH A MAGNETIC CURRENT SENSOR, AND CIRCUIT BREAKER COMPRISING SUCH A MIXED CURRENT SENSOR

(30) Priorité: 20.09.2022 FR 2209497
(43) Date de publication de la demande: 10.04.2024
(73) Titulaire: SCHNEIDER ELECTRIC INDUSTRIES SAS, 92500 Rueil-Malmaison (FR)
(72) Inventeur: LOGLISCI, David, 38410 Vaulnaveys-le-Haut (FR)
(74) Mandataire: Lavoix

(56) Documents cités:
- FR-A1- 2 990 759
- FR-A1- 2 998 059
- FR-A1- 3 030 763
- US-A1- 2019 302 151

## Description

La présente invention concerne un capteur magnétique de courant. Elle concerne également un capteur de courant mixte, comportant un tel capteur magnétique de courant. Elle concerne aussi un disjoncteur comportant un tel capteur de courant mixte.

Les capteurs magnétiques de courant sont des transformateurs de courant permettant de disposer, à partir d'un courant primaire, d'un courant secondaire d'alimentation. Ces capteurs magnétiques de courant comportent typiquement un circuit magnétique, qui est traversé par un conducteur électrique formant circuit primaire, et un bobinage électrique, qui est enroulé autour d'une portion du circuit magnétique et aux extrémités duquel on dispose du courant secondaire. Un tel capteur magnétique de courant est notamment utilisable dans un capteur de courant mixte où, en plus de traverser le circuit magnétique du capteur magnétique de courant, le conducteur électrique formant circuit primaire traverse un bobinage de Rogowski dont les extrémités sont connectées à un circuit électronique d'acquisition et de mesure du courant primaire, c'est-à-dire du courant électrique circulant dans le conducteur électrique formant circuit primaire, ce circuit électronique étant alimenté par le bobinage du capteur magnétique de courant. De tels capteurs de courant mixtes sont notamment utilisés dans des disjoncteurs de forte puissance dont l'ouverture est commandée par le circuit électronique précité. FR 2 990 759 A1 divulgue par exemple un tel capteur de courant mixte, dont le capteur magnétique inclut un bobinage électrique, sans que les aménagements relatifs au raccordement des deux extrémités de ce bobinage ne soient détaillés.

L'invention s'intéresse plus spécifiquement aux capteurs magnétiques de courant dans lesquels une bobine isolante est interposée entre le circuit magnétique, dont la portion précitée est reçue à l'intérieur de la bobine, et le bobinage, qui est bobiné sur la bobine. Cette bobine supporte deux broches de raccordement, qui sont respectivement connectées aux extrémités du bobinage et qui permettent de raccorder des éléments électriques pour conduire le courant fourni par le bobinage jusqu'à une charge à alimenter, telle que le circuit électronique précité. En pratique, le montage de ces broches de raccordement sur la bobine doit tenir compte de contraintes importantes liées aux différentes opérations d'assemblage du capteur magnétique de courant, en particulier les opérations de soudure entre la broche de raccordement et, d'une part, les extrémités du bobinage et, d'autre part, les éléments électriques reliant la broche de raccordement à la charge à alimenter. Il en résulte que les broches de raccordement sont généralement montées sur la bobine simplement par interférence mécanique, typiquement par coincement/clipsage.

Les broches de raccordement peuvent être à l'origine de défaillances conduisant à la rupture de la connexion entre le bobinage et la charge à alimenter, dont les conséquences peuvent être particulièrement graves lorsque le capteur magnétique de courant est intégré à un disjoncteur de forte puissance. En effet, en service, les capteurs magnétiques de courant peuvent être soumis à des températures de fonctionnement et/ou des vibrations opératoires telles que les broches de raccordement risquent de se désolidariser progressivement de la bobine, jusqu'à rompre le fil du bobinage, et/ou de cisailler une portion du fil du bobinage, disposée en travers d'une arête des broches de raccordement. La fixation des broches de raccordement sur la bobine peut être renforcée par de la colle ou de la résine, qui est appliquée de manière à enrober ensemble chacune des broches de raccordement et la partie de la bobine où cette broche de raccordement est montée. Cette solution est efficace mais ne donne pas complètement satisfaction, notamment d'un point de vue environnemental et de répétabilité.

Le but de la présente invention est de proposer un capteur magnétique de courant amélioré, dont le montage des broches de raccordement sur la bobine est robuste, fiable et maitrisé.

A cet effet, l'invention a pour objet un capteur magnétique de courant, tel que défini à la revendication 1.

Une des idées à la base de l'invention est de mettre en œuvre une solution totalement mécanique pour assurer le montage des broches de raccordement sur la bobine, en particulier sans recourir à de la colle ou des produits chimiques similaires, tout en tenant compte des contraintes d'assemblage du reste du capteur magnétique de courant. A cet effet, l'invention prévoit d'intégrer à chaque broche de raccordement deux languettes en saillie du corps principal de la broche de raccordement, qui sont pliées contre une paroi latérale du logement que la bobine délimite pour recevoir ce corps principal, ce pliage étant conçu pour verrouiller en position le corps principal dans le logement et donc retenir en place la broche de raccordement par rapport à la bobine. La conformation pliée des languettes leur permet de rendre robuste et fiable le montage de la broche de raccordement sur la bobine, tout en leur évitant de s'étendre en travers de l'intérieur de la bobine, où est reçue une portion du circuit magnétique. En particulier, le montage verrouillé de la broche de raccordement sur la bobine résiste à des conditions de fonctionnement courantes lorsque le capteur magnétique de courant est utilisé dans un disjoncteur de forte puissance, en résistant notamment à des températures de l'ordre de 150°C et à des vibrations sous 8g. La solution de l'invention s'avère ainsi particulièrement pratique et efficace, sans nécessiter de modifier ou d'adapter le circuit magnétique et le bobinage, et elle est simple à mettre en œuvre, en particulier en incluant dans les opérations d'assemblage du capteur magnétique de courant conforme à l'invention une opération de pliage des languettes puis, si besoin, une opération de coupage/arasage des languettes au niveau de leur extrémité libre. De plus, comme détaillé par la suite, le corps principal de chaque broche de raccordement peut avantageusement intégrer, en dehors des deux languettes, des aménagements permettant de renforcer davantage la fixation à la bobine et/ou d'opérer efficacement la connexion électrique avec le bobinage et avec une piste reliant la broche de raccordement à une charge et/ou d'éviter de prolonger la broche de raccordement dans une région hors du logement où elle risque de cisailler le fil du bobinage.

Ainsi, des caractéristiques additionnelles avantageuses du capteur magnétique de courant conforme à l'invention sont spécifiées aux revendications 2 à 12.

L'invention a également pour objet un capteur de courant mixte, tel que défini à la revendication 13.

L'invention a aussi pour objet un disjoncteur, tel que défini à la revendication 14.

L'invention sera mieux comprise à la lecture de la description qui va suivre, donnée uniquement à titre d'exemple et faite en se référant aux dessins sur lesquels :
- la figure 1 est une vue en perspective d'un disjoncteur conforme à l'invention ;
- la figure 2 est une vue en perspective selon la flèche Il de la figure 1 ;
- la figure 3 est une coupe selon le plan III de la figure 2 ;
- la figure 4 est une vue en perspective d'un capteur de courant mixte conforme à l'invention, appartenant au disjoncteur des figures précédentes ;
- la figure 5 est une vue en perspective d'un éclaté du capteur de courant mixte de la figure 4 ;
- la figure 6 est une vue similaire à la figure 5, sous un angle d'observation différent ;
- la figure 7 est une vue en perspective d'une partie d'un capteur magnétique de courant conforme à l'invention, appartenant au capteur de courant mixte des figures 4 à 6 ;
- la figure 8 est une vue en perspective d'une partie de seulement certains composants du capteur magnétique de courant de la figure 7 ;
- la figure 9 est une vue similaire à la figure 8, montrant une autre partie du capteur magnétique de courant ;
- la figure 10 est une coupe selon le plan X de la figure 8 ;
- la figure 11 est une vue en perspective d'un des composants de la figure 8, montré seul ;
- la figure 12 est une vue en perspective illustrant les composants montrés sur les figures 8 à 11 avant leur assemblage ; et
- les figures 13 et 14 sont des vues en perspective illustrant des opérations successives d'assemblage des composants de la figure 11.

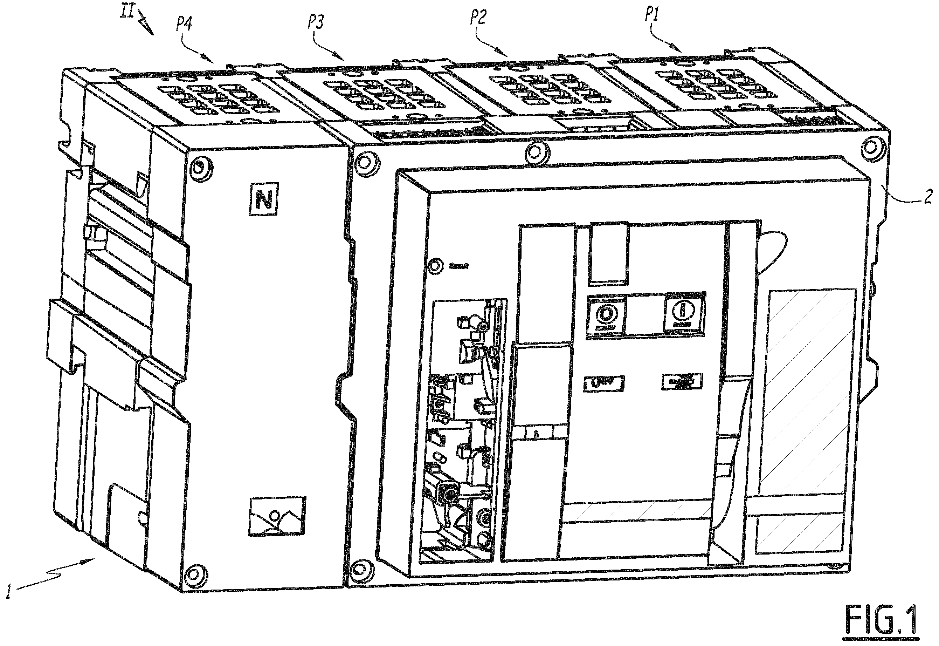

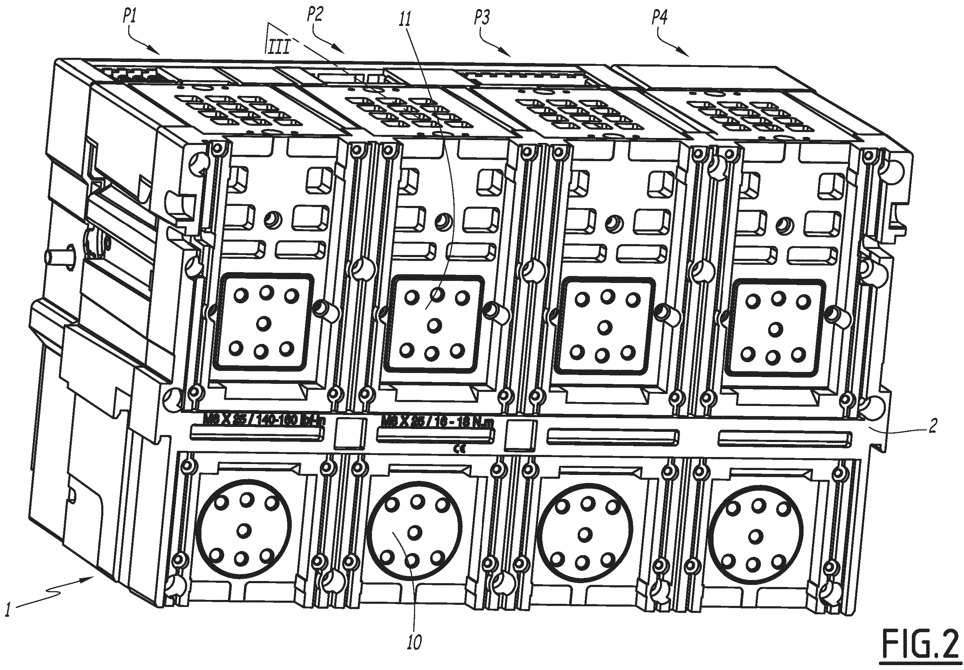

Sur les figures 1 à 3 est représenté un disjoncteur 1 à coupure dans l'air, qui permet de protéger des systèmes électriques contre des conditions anormales, comme des surtensions, des courts-circuits ou des surintensités. Le disjoncteur 1 est typiquement un disjoncteur de forte puissance, notamment à haute intensité dans le sens où, à l'état normalement fermé du disjoncteur 1, le disjoncteur 1 autorise la circulation à travers lui d'un courant permanent, continu ou bien alternatif, dont l'intensité est comprise entre quelques centaines et quelques milliers d'ampères, notamment entre 500A et 7500A.

Le disjoncteur 1 est ici multipolaire, en étant destiné à être utilisé dans un circuit électrique comportant plusieurs pôles électriques. Dans l'exemple illustré sur les figures, le disjoncteur 1 comporte quatre pôles P1, P2, P3 et P4 indépendants. En variante non-représentée, le disjoncteur 1 comporte un nombre différent de pôles, par exemple 2 ou 3. Egalement en variante non représentée, le disjoncteur 1 ne comporte qu'un seul pôle.

Le disjoncteur 1 comporte une enveloppe 2 isolante, qui supporte les pôles P1 à P4. L'enveloppe 2 est par exemple réalisée en une matière plastique. L'enveloppe 2 délimite un volume interne, qui est essentiellement fermé et qui, ici, est réparti en quatre compartiments séparés, respectivement associés aux pôles P1 à P4.

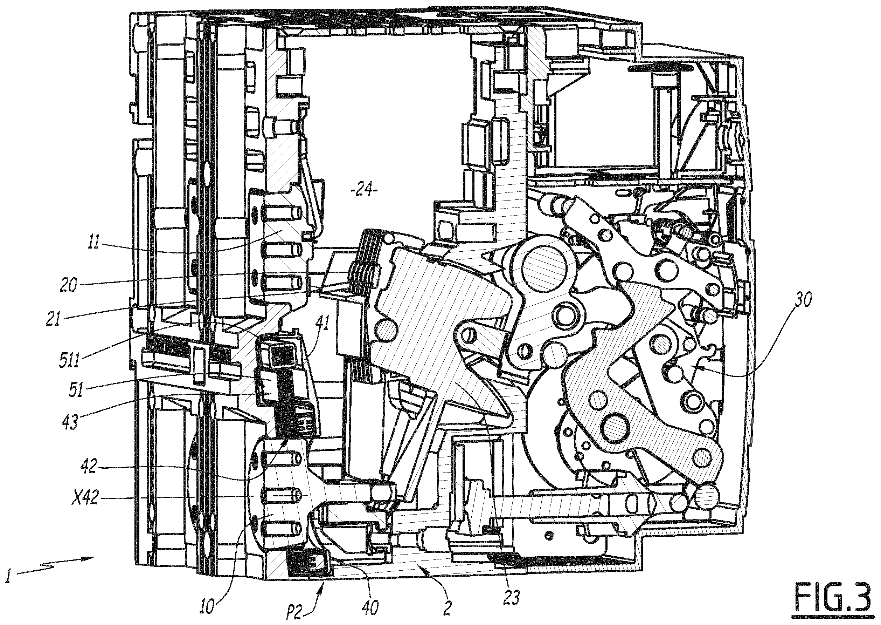

Chacun des pôles P1 à P4 étant identique aux autres pôles, on ne décrit ci-après en détail que l'un d'entre eux, à savoir le pôle P2 qui est montré en coupe sur la figure 3. La description donnée pour le pôle P2 s'applique à chacun des autres pôles P1, P3 et P4.

Le pôle P2 comporte deux plots terminaux 10 et 11 qui permettent de raccorder le pôle P2 à un circuit électrique à protéger par le disjoncteur 1. Les plots terminaux 10 et 11, qui sont réalisés en un matériau électriquement conducteur, généralement un métal tel que du cuivre, sont portés par l'enveloppe 2 de manière à être raccordables électriquement depuis l'extérieur de l'enveloppe 2 au circuit électrique à protéger. Ici, les plots terminaux 10 et 11 traversent une paroi dédiée de l'enveloppe 2, en émergeant, de part et d'autres de cette paroi dédiée, à l'extérieur de l'enveloppe 2 et à l'intérieur de l'enveloppe 2, autrement dit dans le volume interne de cette dernière, plus précisément à l'intérieur du compartiment de ce volume interne, associé au pôle P2.

Le pôle P2 comporte également deux éléments de contact 20 et 21 qui sont respectivement raccordés aux plots terminaux 10 et 11 tout en étant déplaçables l'un par rapport à l'autre entre une position fermée, qui n'est pas représentée, et une position ouverte, qui est représentée sur la figure 3. Dans la position fermée, les éléments de contact 20 et 21 sont en contact direct l'un avec l'autre et permettent la circulation d'un courant électrique entre les plots terminaux 10 et 11. Dans leur position ouverte, les éléments de contact 20 et 21 sont écartés l'un de l'autre et interrompent la circulation électrique entre les plots terminaux 10 et 11.

Dans la forme de réalisation considérée sur les figures, l'élément de contact 20 est porté fixement par un bras mobile 23 qui est raccordé électriquement au plot terminal 10, tandis que l'élément de contact 21 est porté fixement par le plot terminal 11 qui est lui-même porté fixement par l'enveloppe 2.

Dans tous les cas, les éléments de contact 20 et 21 sont disposés dans une chambre de coupure 24 associée au pôle P2. La chambre de coupure 24 est délimitée à l'intérieur de l'enveloppe 2, en formant ainsi une partie du volume interne de cette dernière, plus précisément une partie du compartiment de ce volume interne, associé au pôle P2. La chambre de coupure 24 est remplie d'air et entoure les éléments de contact 20 et 21 de manière à favoriser l'extinction de l'arc électrique se formant entre les éléments de contact 20 et 21 lorsque ces derniers passent de leur position fermée à leur position ouverte. Entre sa formation et son extinction, l'arc électrique ionise l'air présent dans la chambre de coupure 24, ce qui génère des gaz, dit gaz de coupure, qui sont partiellement ionisés et qui contiennent des particules en suspension, telles que des suies et/ou des particules métalliques. La formation de cet arc électrique crée dans la chambre de coupure 24 une surpression qui doit être supportée par les parties de l'enveloppe 2, délimitant la chambre de coupure 24, et par les composants du disjoncteur 1, disposés dans la chambre de coupure 24.

Le pôle P2 comporte aussi un mécanisme 30 permettant d'ouvrir le disjoncteur 1, c'est-à-dire de déplacer les éléments de contact 20 et 21 de la position fermée vers la position ouverte, lorsqu'une anomalie de fonctionnement est détectée. L'anomalie de fonctionnement est par exemple une surcharge, un court-circuit ou une surintensité du courant électrique qui circule dans le circuit à protéger par le disjoncteur 1, pour au moins l'un des pôles P1 à P4. La détection de cette anomalie de fonctionnement est assurée par le disjoncteur 1 lui-même, comme expliqué plus en détail par la suite. Le mécanisme 30 est agencé à l'intérieur de l'enveloppe 2, plus précisément dans le compartiment du volume interne de cette dernière, associé au pôle P2. En pratique, le mécanisme 30 est connu en soi dans le domaine et ne sera donc pas décrit ici plus avant. Autrement dit, les spécificités du mécanisme 30 ne sont pas limitatives. Dans l'exemple de réalisation considéré ici, le mécanisme 30 est conçu pour mettre en mouvement le bras mobile 23 afin de passer les éléments de contact 20 et 21 entre leurs positions fermée et ouverte. Le mécanisme 30 est avantageusement conçu pour, lorsqu'il passe les éléments de contact 20 et 21 de leur position fermée à leur position ouverte, entrainer l'ouverture des éléments de contact des autres pôles P1, P3 et P4 du disjoncteur 1, notamment par l'intermédiaire de mécanismes, similaires au mécanisme 30 du pole P2, qui appartiennent respectivement aux pôles P1, P3 et P4.

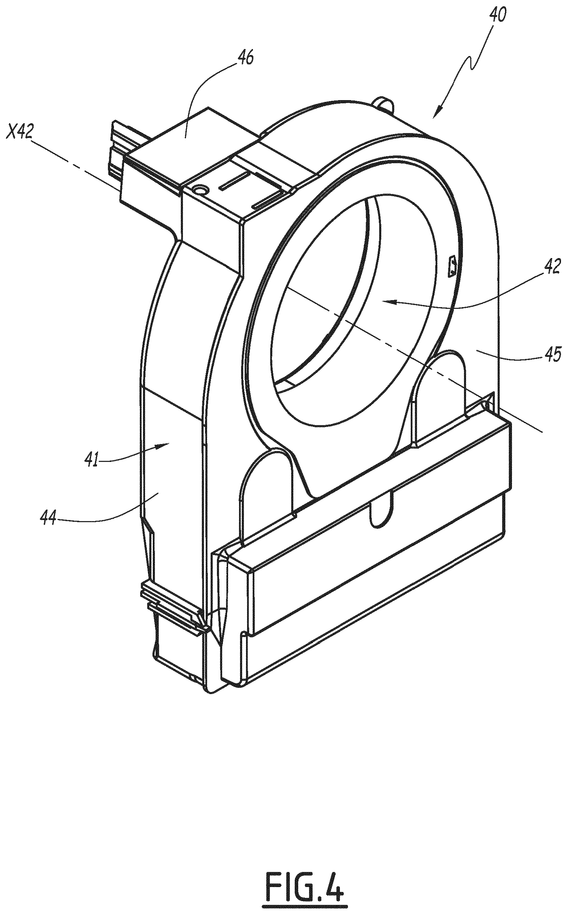

Le pole P2 comporte également un capteur de courant mixte 40, qui est visible à la figure 3 et qui est représenté seul sur les figures 4 à 6.

Comme bien visible sur la figure 3, le capteur de courant mixte 40 est agencé à l'intérieur de l'enveloppe 2, plus précisément dans le compartiment du volume interne de cette dernière, associé au pôle P2, en étant disposé dans la chambre de coupure 24.

Comme bien visible sur les figures 3 et 4, le capteur de courant mixte 40 comporte un boitier 41 qui est traversé par un passage 42 suivant un axe de passage X42 sur lequel le passage 42 est centré. A l'état assemblé du disjoncteur 1, le plot terminal 10 est reçu, ici de manière complémentaire, dans le passage 42, en s'étendant parallèlement à l'axe de passage X42, voire, comme ici, en étant aligné sur l'axe de passage X42. Le boitier 41 se retrouve ainsi traversé, via son passage 42, par le plot terminal 10, et est agencé dans la chambre de coupure 24 en étant disposé, suivant l'axe de passage X42, contre une partie de l'enveloppe 2, elle aussi traversée par le plot terminal 10 suivant l'axe de passage X42.

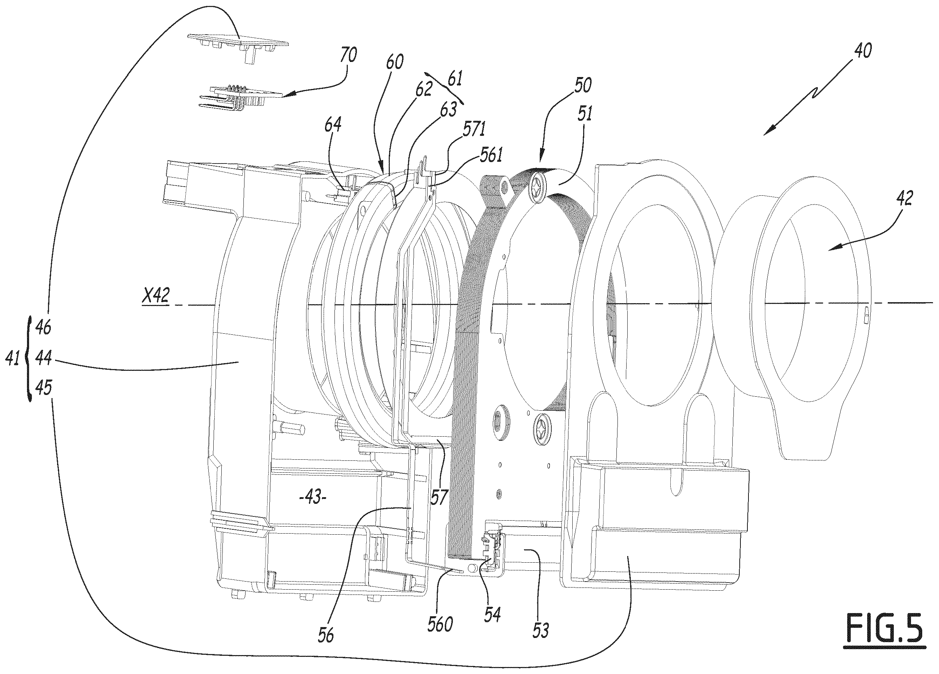

Comme bien visible sur les figures 3 et 5, le boitier 41 délimite également un volume interne 43 qui est séparé du passage 42, en entourant le passage 42 tout autour de l'axe de passage X42. Dans l'exemple de réalisation considéré sur les figures, le boitier 41 comporte à cet effet une coquille 44 et un capot 45 qui est assemblé fixement à la coquille 44 en la fermant de manière à délimiter le volume interne 43 entre la coquille 44 et le capot 45. D'autres formes de réalisation sont envisageables pour le boitier 41.

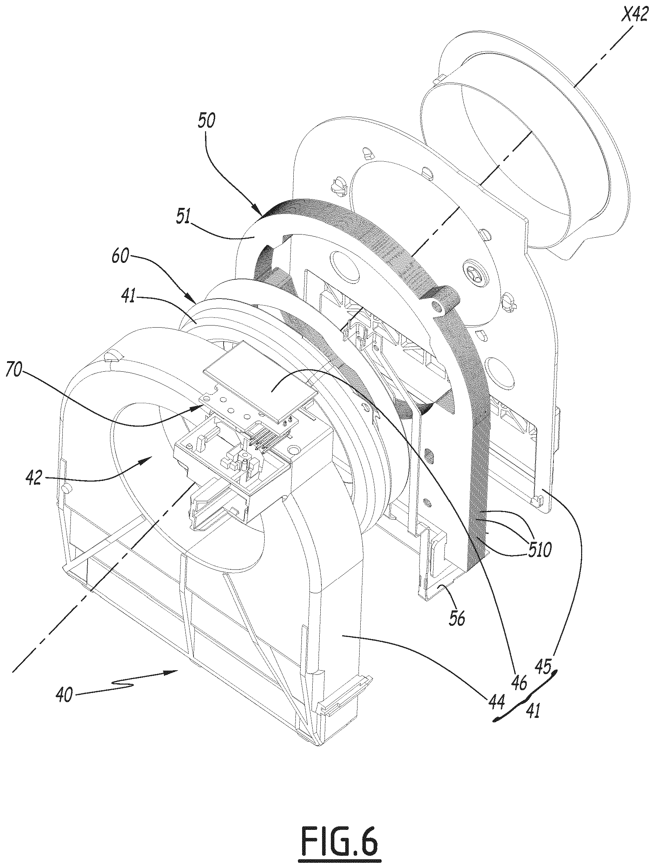

Comme bien visible sur les figures 5 et 6, le capteur de courant mixte 40 comporte également un capteur magnétique de courant 50, un dispositif de mesure de courant 60 et un circuit électronique 70, qui vont être décrits plus en détail ci-après et qui sont tous logés dans le volume interne 43 du boitier 41 à l'état assemblé du capteur de courant mixte 40.

Le capteur magnétique de courant 50 comporte un circuit magnétique 51 qui est agencé dans le volume interne 43 du boitier 41 de manière à entourer le passage 42. Dans la forme de réalisation considérée ici, le circuit magnétique 51 comporte plusieurs plaques métalliques 510 empilées en contact direct les unes avec les autres suivant une direction parallèle à l'axe de passage X42, ces plaques métalliques 510 étant traversées, de part en part de leur empilement, par le passage 42. D'autres formes de réalisation sont envisageables pour le circuit magnétique 51.

Avant de décrire le reste du capteur magnétique de courant 50, on décrit plus en détail ci-dessous le dispositif de mesure de courant 60 et le circuit électronique 70, en s'appuyant sur les figures 5 et 6.

Le dispositif de mesure de courant 60 comporte un bobinage de Rogowski 61 qui est agencé dans le volume interne 43 du boitier 41 de manière à entourer le passage 42. Dans l'exemple de réalisation considéré sur les figures, le bobinage de Rogowski 61 comporte un fil électrique 62 métallique, qui n'est pas représenté en détail sur les figures et qui est par exemple en cuivre ou en un alliage à base de cuivre. Le fil électrique 62 est bobiné sur une carcasse 63 isolante, réalisée dans un matériau amagnétique. La carcasse 63 entoure le passage 62 tout autour de l'axe de passage X42 et, ici, présente une forme globalement annulaire à base circulaire, centrée sur l'axe de passage X42. D'autres formes de réalisation sont envisageables pour le bobinage de Rogowski 61.

Dans tous les cas, le circuit magnétique 51 du capteur magnétique de courant 50 et le bobinage de Rogowski 61 du dispositif de mesure de courant 60 sont conçus pour, en service, entourer un même conducteur électrique formant un circuit primaire pour chacun d'eux, c'est-à-dire un circuit primaire pour le circuit magnétique 51 et un circuit primaire pour le bobinage de Rogowski 61, ce conducteur électrique traversant le capteur de courant mixte 40 par le passage 42 de son boitier 41. Dans la forme de réalisation considérée ici, où le capteur de courant mixte 40 est utilisé dans le disjoncteur 1, le conducteur électrique formant un circuit primaire pour le circuit magnétique 51 et pour le bobinage de Rogowski 61 est constitué par le plot terminal 10 qui, à l'état assemblé du disjoncteur 1, est reçu dans le passage 42 et se retrouve ainsi entouré, tout autour de l'axe de passage X42, par à la fois le circuit magnétique 51 et le bobinage de Rogowski 61, comme montré sur la figure 3.

Le bobinage de Rogowski 61 est raccordé au circuit électronique 70 aux fins du traitement par ce dernier du courant électrique circulant dans le bobinage de Rogowski 61. La forme de réalisation du raccordement entre le bobinage de Rogowski 61 et le circuit électronique 70 n'est pas limitative. Dans l'exemple de réalisation considéré dans les figures, le dispositif de mesure de courant 60 comporte à cet effet une cassette de raccordement 64 qui, tout en assurant la connexion électrique entre des extrémités du bobinage de Rogowski 61 et des bornes du circuit électronique 70, permet d'assurer la fixation et le positionnement relatifs entre le bobinage de Rogowski 61 et le circuit électronique 70 dans le boitier 41. En particulier, la cassette de raccordement 64 s'étend depuis le bobinage de Rogowski 61 dans un logement dédié du volume interne 43, au fond duquel le circuit électronique 70 est agencé et qui est ici fermé par un couvercle rapporté 46 du boitier 41.

Quelles que soient les spécificités du raccordement entre le bobinage de Rogowski 61 et le circuit électronique 70, ce dernier est configuré pour, à partir du courant électrique circulant dans le bobinage de Rogowski 61, détecter et mesurer le courant électrique circulant dans le conducteur électrique formant le circuit primaire du bobinage de Rogowski 61, autrement dit, ici, pour détecter et mesurer le courant électrique dans le plot terminal 10 à l'état assemblé du disjoncteur 1. En effet, en service, le courant circulant dans le bobinage de Rogowski 61 fournit un signal de mesure représentatif du courant électrique circulant dans le plot terminal 10, le circuit électronique 70 étant conçu pour traiter ce signal de mesure. En particulier, la tension aux bornes du bobinage de Rogowski 61 est directement proportionnelle à l'intensité du courant électrique dans le plot terminal 10. L'absence de noyau magnétique risquant d'être saturé permet une large dynamique de mesure. En pratique, les moyens électroniques d'acquisition et de mesure du courant, qui appartiennent au circuit électronique 70, sont connus en soi dans le domaine et ne seront pas décrits ici plus avant, la forme de réalisation de ces moyens électroniques n'étant pas limitative.

De plus, le circuit électronique 70 est ici conçu pour commander le mécanisme 30 du disjoncteur 1, en lui envoyant un signal d'activation lorsque le traitement opéré par le circuit électronique 70 révèle l'anomalie de fonctionnement précédemment évoquée. Autrement dit, lorsque le circuit électronique 70 détecte une telle anomalie de fonctionnement, le mécanisme 30 est commandé par le circuit électronique 70 pour déplacer les éléments de contact 20 et 21 de leur position fermée vers leur position ouverte.

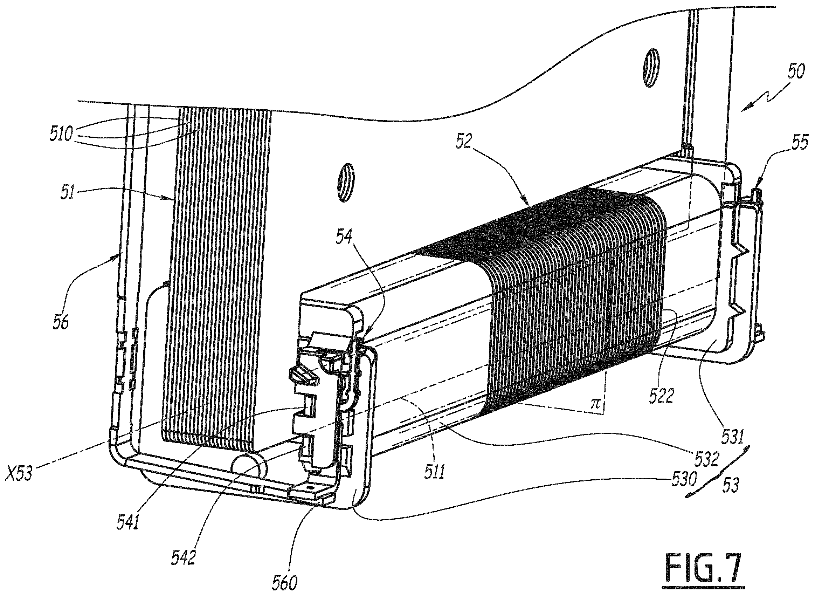

On revient maintenant à la description détaillée du reste du capteur magnétique de courant 50, en s'appuyant plus particulièrement sur les figures 7 à 11.

Le capteur magnétique de courant 50 comporte, en plus de son circuit magnétique 51, un bobinage 52 électrique. Pour des raisons de visibilité, ce bobinage 52 n'est pas représenté sur les figures 3, 5, 6 et 10 et n'est représenté que partiellement et schématiquement sur les figures 7 à 9. Le bobinage 52 est constitué d'un fil métallique, de préférence en cuivre ou en alliage à base de cuivre, qui est enroulé autour d'une portion 511 du circuit magnétique 51, avec interposition d'une bobine 53 isolante, appartenant au capteur magnétique de courant 50. La portion 511 du circuit magnétique 51, qui est indiquée en pointillés sur la figure 7, est ici déportée du passage 42 par rapport à l'axe de passage X42, en étant constituée par la partie du circuit magnétique 51, qui est la plus éloignée du passage 42.

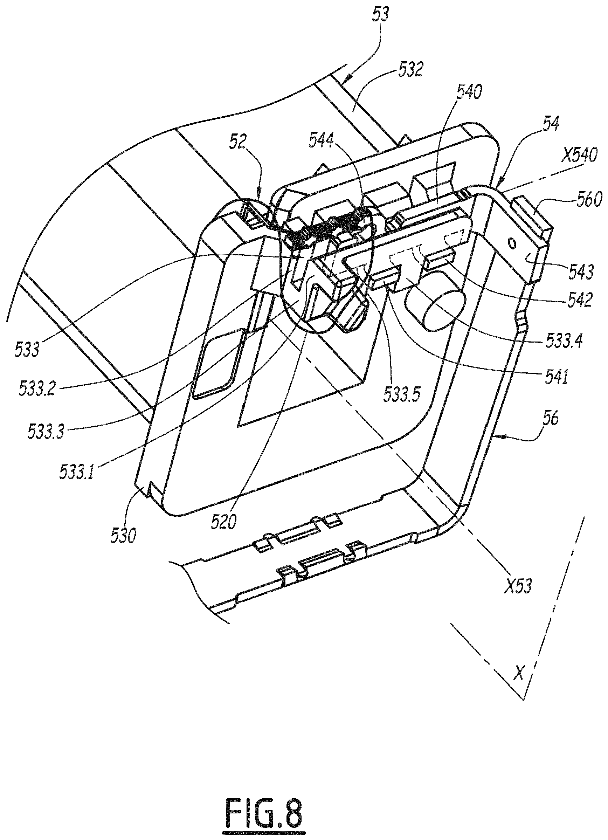

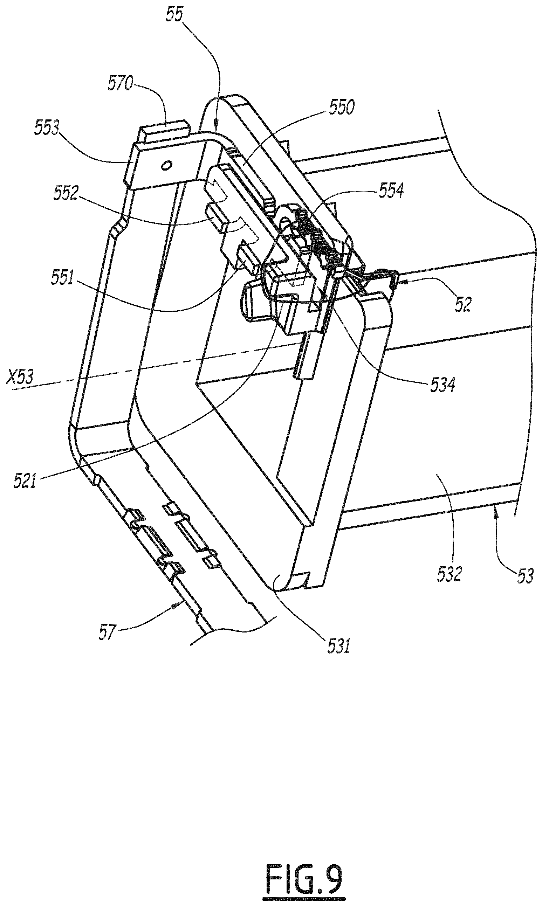

Plus précisément, le bobinage 52 inclut deux extrémités 520 et 521, qui ne sont respectivement représentées que sur les figures 8 et 9 et qui sont respectivement constituées par les extrémités opposées du fil métallique constituant ce bobinage. La bobinage 52 inclut également une partie courante enroulée 522, qui n'est montrée schématiquement que sur la figure 7 et qui relie les extrémités 520 et 521 l'une à l'autre.

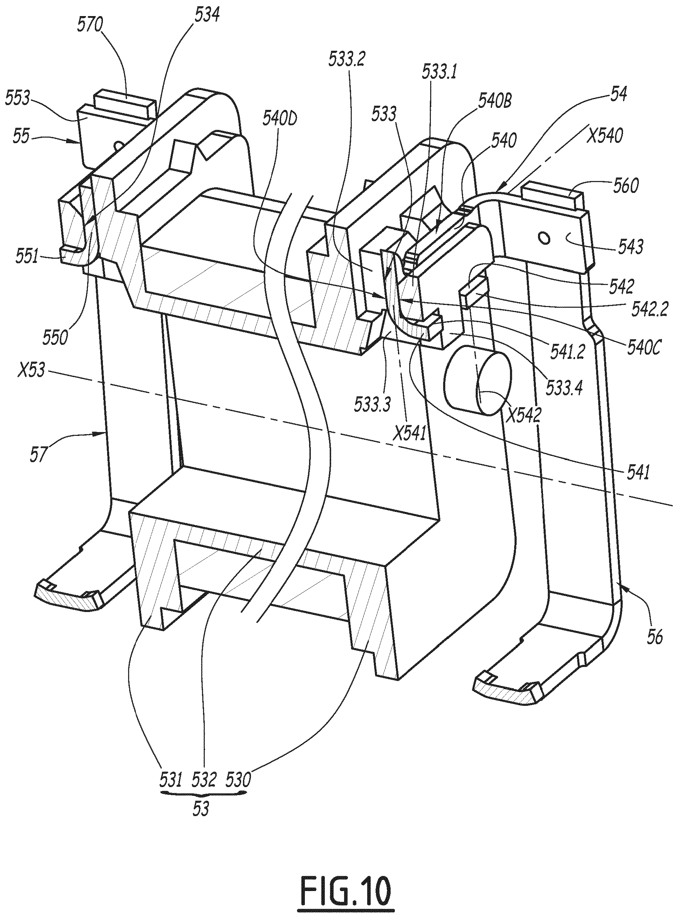

La bobine 53, qui est réalisée dans un matériau amagnétique, définit un axe de bobine X53, sur lequel la bobine 53 est centrée et le long duquel la bobine 53 est intérieurement creuse. A l'état assemblé du capteur magnétique de courant 50, l'axe de bobine X53 s'étend à distance et transversalement à l'axe de passage X42, notamment de manière orthogonale à cet axe de passage X42. Dans la forme de réalisation considérée sur les figures, la bobine 53 présente une forme tubulaire, centrée sur l'axe de bobine X53 et présentant une section transversale carrée à coins arrondis. D'autres géométries sont envisageables pour la bobine 53. Dans tous les cas, comme bien visible sur les figures 7 et 10, la bobine 53 inclut deux parties terminales 530 et 531, qui sont opposées l'une à l'autre suivant l'axe de bobine X53 et qui sont reliées l'une à l'autre par une partie courante allongée 532 de la bobine 53. La bobine 53 est interposée, radialement à l'axe de bobine X53, entre la portion 511 du circuit magnétique 51 et le bobinage 52. La portion 511 du circuit magnétique 51 est reçue à l'intérieur de la bobine 53, en s'étendant successivement à l'intérieur de la partie terminale 530, de la partie courante allongée 532 et de la partie terminale 531, ainsi qu'en émergeant à l'extérieur de la bobine 53 depuis chacune des parties terminales 530 et 531 suivant l'axe de bobine X53. Le bobinage 52 est bobiné coaxialement à la bobine 53, sa partie courante enroulée 522 étant roulée sur plusieurs tours autour et le long de la partie courante allongée 532 de la bobine 53 et se retrouve ainsi agencée autour de la portion 511 du circuit magnétique 51, tandis que les extrémités 520 et 521 du bobinage 52 sont disposées, suivant l'axe de bobine X53, respectivement au niveau des parties terminales 530 et 531 de la bobine 53.

Comme montré sur les figures 7 à 10, le capteur magnétique de courant 50 comporte également deux broches de raccordement 54 et 55, qui sont respectivement montées sur les parties terminales 530 et 531 de la bobine 53 et qui sont respectivement connectées électriquement aux extrémités 520 et 521 du bobinage 52. La broche de raccordement 54 permet d'assurer le raccordement électrique de l'extrémité 520 du bobinage 52 tout en assurant la liaison mécanique fixe de cette extrémité 520 du bobinage 52 avec la partie terminale 530 de la bobine 53. La broche de raccordement 55 permet d'assurer le raccordement électrique de l'extrémité 521 du bobinage 52 tout en assurant la liaison mécanique fixe de cette extrémité 521 du bobinage 52 avec la partie terminale 531 de la bobine 53. En pratique, les broches de raccordement 54 et 55 sont à cet effet réalisées en un matériau métallique.

Avant de décrire plus en détail les broches de raccordement 54 et 55, on notera que le capteur magnétique de courant 50 comporte également deux pistes électriques 56 et 57 qui relient respectivement les broches de raccordement 54 et 55 à une charge de manière que le bobinage 52 puisse alimenter cette charge. Dans la forme de réalisation considérée ici, la charge précitée est le circuit électronique 70 : ainsi, à l'état assemblé du capteur de courant mixte 40, le circuit électronique 70 est alimenté par le bobinage 52 via les pistes électriques 56 et 57, comme bien visible sur les figures 5 à 10.

Chacune des pistes électriques 56 et 57 comporte deux extrémités opposées 560 et 561, respectivement 570 et 571. L'extrémité 560 de la piste électrique 56, respectivement 570 de la piste électrique 57, est connectée, notamment par soudure, à la broche de raccordement 54, respectivement 55, comme détaillé par la suite en lien avec la description détaillée des broches de raccordement 54 et 55. L'extrémité 561 de la piste électrique 56, respectivement 571 de la piste électrique 57, est connectée, notamment par soudure, au circuit électronique 70, les spécificités de cet assemblage de connexion entre les pistes électriques 56 et 57 et le circuit électronique 70 n'étant pas limitatives.

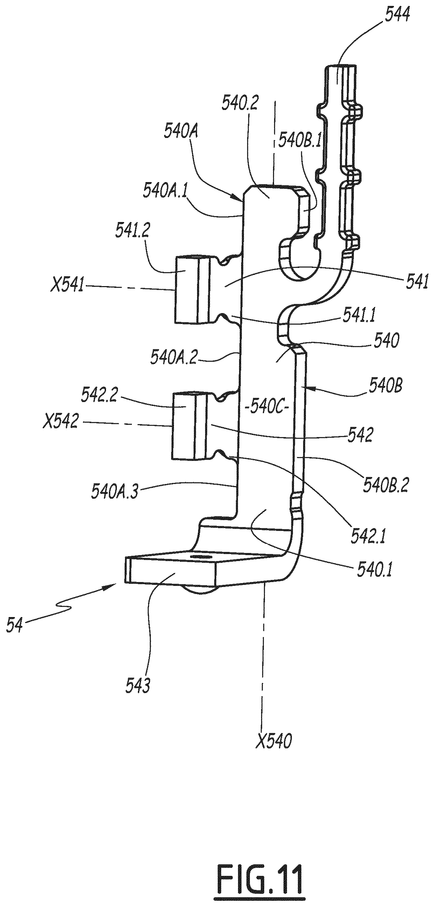

En revenant maintenant à la description détaillée des broches de raccordement 54 et 55, on notera que ces deux broches de raccordement 54 et 55 ne sont pas identiques l'une à l'autre dans le sens où elles ne sont pas interchangeables l'une avec l'autre du fait de leur agencement structurel, qui va être détaillé ci-après. Ceci étant, les deux broches de raccordement 54 et 55 sont fonctionnellement similaires l'une à l'autre, en étant structurellement adaptées à la partie terminale 530 ou 531 de la bobine 53, sur laquelle elles sont respectivement montées. Dans la forme de réalisation considérée sur les figures, les broches de raccordement 54 et 55 sont avantageusement symétriques l'une de l'autre par rapport à un plan géométrique π, qui est indiqué sur la figure 7 et qui est perpendiculaire à l'axe de bobine X53. Dès lors, par commodité, on va décrire ci-après en détail la broche de raccordement 54, montrée seule à la figure 11, étant entendu que la description de la broche de raccordement 55 s'en déduit directement, notamment par symétrie par rapport au plan géométrique π.

La broche de raccordement 54 comporte un corps principal 540. Comme bien visible sur les figures 8 et 10, le corps principal 540 est reçu de manière complémentaire dans un logement 533 ménagé dans la partie terminale 530 de la bobine 53. Le logement 533 est fermé à la fois par deux parois latérales 533.1 et 533.2, qui appartiennent à la partie terminale 530 et qui sont agencées en regard l'une de l'autre suivant une direction parallèle à l'axe de bobine X53, et par une paroi de fond 533.3, qui appartient à la partie terminale 530 et qui relie l'un à l'autre, parallèlement à l'axe de bobine X53, les bords respectifs, tournés vers l'axe de bobine X53, des parois latérales 533.1 et 533.2. Le logement 533 est ouvert entre les parois latérales 533.1 et 533.2 en dehors de la paroi de fond 533.3, en particulier entre les bords respectifs, tournés à l'opposé de l'axe de bobine X53, des parois latérales 533.1 et 533.2.

Comme bien visible sur les figures 8, 10 et 11, le corps principal 540 présente une forme allongée suivant un axe de corps X540. A l'état assemblé du capteur magnétique de courant 50, l'axe de corps X540 s'étend à distance et transversalement à l'axe de bobine X53, en particulier de manière orthogonale à l'axe de bobine X53.

Comme indiqué sur la figure 11, le corps principal 540 inclut deux extrémités longitudinales 540.1 et 540.2, qui sont opposées l'une à l'autre suivant l'axe de corps X540, et de l'une à l'autre desquelles le corps principal s'étend suivant l'axe de corps. De plus, le corps principal 540 est pourvu :
- d'une face latérale 540A qui, à l'état assemblé du capteur magnétique de courant 50, est tournée vers l'axe de bobine X53,
- d'une face latérale 540B, qui est opposée à la face latérale 540A et qui, à l'état assemblé du capteur magnétique de courant 50, est tournée à l'opposé de l'axe de bobine X53, et
- de deux faces latérales 540C et 540D, qui relient l'une à l'autre les faces latérales 540A et 540B et qui sont de part et d'autre du corps principal suivant une direction parallèle à l'axe de bobine X53.

La broche de raccordement 54 comporte également deux languettes 541 et 542. Comme bien visible sur les figures 10 et 11, les languettes 541 et 542 sont en saillie de la face latérale 540A du corps principal 540, en courant depuis des extrémités respectives 541.1 et 542.1 de jonction avec le corps principal 540, jusqu'à des extrémités libres respectives 541.2 et 542.2. Comme bien visible sur les figures 8, 10 et 11, les languettes 541 et 542 sont distantes l'une de l'autre suivant l'axe de corps X540. A leur extrémité 541.1, 542.1 de jonction avec le corps principal 540, les languettes 541 et 542 s'étendent depuis la face latérale 540A du corps principal 540 suivant des axes de languette respectifs X541 et X542, qui sont parallèles l'un à l'autre et qui, à l'état assemblé du capteur magnétique de courant 50, s'étendent chacun transversalement à l'axe de bobine X53 et à l'axe de corps X540, en particulier de manière orthogonale à l'axe de bobine X53 et de manière perpendiculaire à l'axe de corps X540. Entre leur extrémité 541.1, 542.1 de jonction avec le corps principal 540 et leur extrémité libre 541.2, 542.2, les languettes 541 et 542 sont pliées contre une même paroi latérale du logement 533, à savoir la paroi latérale 533.1, de manière à retenir en position la broche de raccordement 54 par rapport à la bobine 53.

En pratique, pour permettre aux languettes 541 et 542 d'être pliées contre la paroi latérale 533.1 du logement 533, les languettes 541 et 542 passent au travers de la paroi de fond 533.3 qui est ajourée en conséquence, comme bien visible sur la figure 10.

Afin d'améliorer l'efficacité et la pérennité de la retenue en position de la broche de raccordement 54 sur la bobine 53 par la conformation pliée des languettes 541 et 542, chacune de ces languettes 541 et 542 est avantageusement pliée à 95° ± 5° contre la paroi latérale 533.1 du logement 533. De cette façon, une éventuelle détente de dépliage n'altère pas la retenue en position de la broche de raccordement 55 sur la bobine 53.

La retenue en position de la broche de raccordement 54 par rapport à la partie terminale 530 de la bobine 53 par les languettes 541 et 542 est avantageusement prévue parallèlement aux axes de languette X541 et X542. À cet effet, comme bien visible sur les figures 8 et 10, les languettes 541 et 542 sont pliées avantageusement de façon à se retrouver en butée, suivant une direction parallèle aux axes de languette X541 et X542 et orientée à l'opposé de l'axe de bobine X53, contre la paroi latérale 533.1 du logement 533, en particulier contre un bord de cette paroi latérale 533.1, tourné vers l'axe de bobine X53. De cette façon, les languettes 541 et 542 empêchent le corps principal 540 de la broche de raccordement 54 de sortir du logement 533 suivant cette direction. Suivant une direction opposée à la direction précitée, c'est-à-dire une direction parallèle aux axes de languette X541 et X542 mais tournée vers l'axe de bobine X53, la face latérale 540A du corps principal 540 se retrouve avantageusement appuyée contre la paroi de fond 533.3 du logement 533 : plus précisément, cette face latérale 540A du corps principal 540 inclut des surfaces d'appui 540A.1, 540A.2 et 540A.3, qui sont ainsi appuyées contre la paroi de fond 533.3 et qui, comme indiqué sur la figure 11, sont situées de part et d'autre, suivant l'axe de corps X540, d'au moins une des languettes 541 et 542, voire, comme ici, des deux languettes 541 et 542. De cette façon, la broche de raccordement 54 est stabilisée efficacement dans le fond du logement 533 parallèlement aux axes de languettes X541 et X542, à des jeux fonctionnels près.

La retenue en position de la broche de raccordement 54 par rapport à la partie terminale 530 de la bobine 53 par les languettes 541 et 542 est aussi avantageusement prévue parallèlement à l'axe de corps X540. À cet effet, comme bien visible sur les figures 8 et 10, les languettes 541 et 542 sont pliées avantageusement de façon à se retrouver en butée, suivant des directions qui sont parallèles à l'axe de corps X540 et opposées l'une à l'autre, contre la paroi latérale 533.1 du logement 533, en particulier contre des parties 533.4 et 533.5 de la paroi latérale 533.1, qui sont en saillie du bord de cette dernière tourné vers l'axe de bobine X53, comme bien visible sur les figures 8 et 10. De cette façon, les languettes 541 et 542 immobilisent le corps principal 540 dans le logement 533 parallèlement à l'axe de corps X540, et ce dans les deux directions opposées possibles.

Quant à la retenue en position de la broche de raccordement 54 parallèlement à l'axe de bobine X53, elle est avantageusement assurée, à des jeux près, par les parois latérales 533.1 et 533.2 du logement 533, dont l'écartement relatif suivant l'axe de bobine X53 est sensiblement égale à l'épaisseur du corps principal 540, c'est-à-dire à la dimension de ce dernier entre ses faces latérales 540C et 540D.

En plus des languettes 541 et 542, la broche de raccordement 54 inclut d'autres aménagements en saillie de son corps principal 540, comme détaillé ci-dessous.

Ainsi, la broche de raccordement 54 inclut un bras 543 qui, comme bien visible sur les figures 8, 10 et 11, s'étend de manière coudée depuis l'extrémité longitudinale 540.1 du corps principal 540, étant remarqué que les languettes 541 et 542 et ce bras 543 sont tous fléchis vers un même côté latéral du corps principal 540, à savoir celui correspondant à sa face latérale 540C. Le bras 543 permet de connecter la broche de raccordement 54 à la piste électrique 56 : à cet effet, le bras 543 est assemblé, notamment par soudure, à la piste électrique 56, plus précisément à l'extrémité 560 de cette dernière. En pratique, l'assemblage par soudure entre le bras 543 et l'extrémité 560 de la piste électrique 56 est avantageusement réalisé par brasage, par exemple avec une brasure en étain.

Dans le prolongement des considérations qui précèdent, il est préférable que, comme dans la forme de réalisation considérée sur les figures, les extrémités libres respectives 541.2 et 542.2 des languettes 541 et 542 n'émergent pas substantiellement de la paroi latérale 533.1 du logement 533. Autrement dit, de préférence, chacune des languettes 541 et 542 est, à son extrémité libre 541.2, 542.2, sensiblement en affleurement avec la paroi latérale 533.1 du logement 533. De cette façon, les opérations d'assemblage, notamment de soudure, entre le bras 543 et la piste électrique 56 sont facilitées dans le sens où ces opérations d'assemblage ne sont pas gênées par la présence des languettes 541 et 542 qui restent essentiellement en retrait de la face de la paroi latérale 533.1, qui est tournée, suivant l'axe de bobine X53, du côté où est fléchi le bras 543.

De plus, la broche de raccordement 54 inclut un mât 544 qui, comme bien visible sur les figures 8 et 11, est en saillie de la face latérale 540B du corps principal 540. Ce mât 544 est coudé vers l'extrémité longitudinale 540.2 du corps principal 540 de manière à s'étendre le long de la face latérale 540B du corps principal 540. Le mât 544 permet de connecter l'extrémité 520 du bobinage 52 à la broche de raccordement 54. À cet effet, l'extrémité 520 du bobinage 52 est assemblée, notamment par soudure, autour du mât 544, comme indiqué schématiquement sur la figure 8. En pratique, comme représenté schématiquement à la figure 8, l'extrémité 520 du bobinage 52 est enroulée une ou quelques fois autour du mât 544, tout en y étant soudée par brasage, par exemple avec une brasure en étain.

Dans la mesure où le bobinage 52 s'étend, au niveau de la partie terminale 530 de la bobine 53, dans la région de cette partie terminale 530 où est situé le mât 544 coudé, il est préférable, comme dans la forme de réalisation considérée sur les figures, que la broche de raccordement 54 ne se prolonge, suivant l'axe de corps X540, depuis l'extrémité longitudinale 540.2 du corps principal 540 à l'extérieur du logement 533, comme bien visible sur la figure 8. En effet, de cette façon, la broche de raccordement 54, en particulier son corps principal 540, ne risque pas d'interférer avec le bobinage 52, hormis au niveau de l'assemblage, notamment soudé, entre l'extrémité 520 du bobinage 52 et le mât 544 : les risques que la broche de raccordement 54 endommage, notamment par cisaillement, le bobinage 52 sont ainsi écartés.

Par ailleurs, suivant un aménagement avantageux dont l'intérêt apparaitra un peu plus loin, la face latérale 540B du corps principal 540 inclut des surfaces d'appui 540B.1 et 540B.2 qui sont situées de part et d'autre, suivant l'axe de corps X540, du mât 544.

Comme indiqué plus haut, la description détaillée qui vient d'être faite de la broche de raccordement 54 s'applique à la broche de raccordement 55, en tenant toutefois compte du fait que, d'une part, la broche de raccordement 55 est montée sur la partie terminale 531 de la bobine 533, et non sur la partie terminale 530 sur laquelle la broche de raccordement 54 est montée, et, d'autre part, la broche de raccordement 55 est connectée à l'extrémité 521 du bobinage 52, et non à l'extrémité 520 à laquelle est connectée la broche de raccordement 54, comme montré sur la figure 9. Ainsi, sans les décrire avec le même niveau de détail que ci-dessus pour la broche de raccordement 54, la broche de raccordement 55 comporte un corps principal 550, deux languettes 551 et 552, un bras 553 et un mât 554 qui sont fonctionnellement similaires à, respectivement, le corps principal 540, les languettes 541 et 542, le bras 543 et le mât 544, en étant d'ailleurs avantageusement respectivement symétriques à ces derniers par rapport au plan géométrique π. Bien entendu, la partie terminale 531 de la bobine 53 est aménagée en conséquence, notamment en ménageant un logement 534 qui est similaire au logement 533, comme bien visible sur la figure 9.

Comme expliqué jusqu'ici, les broches de raccordement 54 et 55 présentent de nombreux intérêts visant à fiabiliser et renforcer la connexion du bobinage 52 au niveau des parties terminales 530 et 531 du bobinage 53.

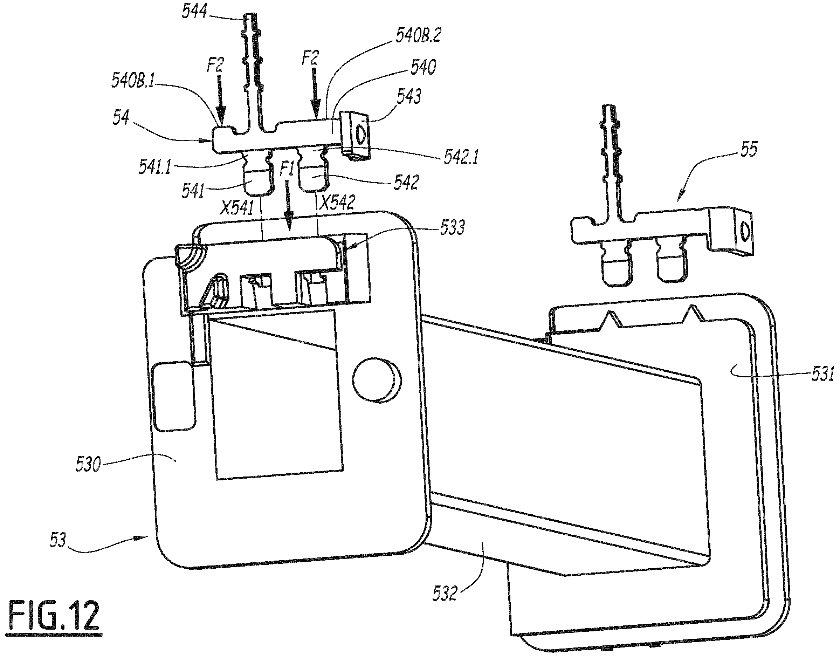

Les broches de raccordement 54 et 55 s'avèrent également particulièrement faciles et pratiques à assembler au reste du capteur magnétique de courant 50. Ainsi, les figures 12 à 14 illustrent trois moments successifs d'opérations d'assemblage entre les broches de raccordement 54 et 55 et la bobine 53. Ci-après, on décrit en détail les opérations d'assemblage relatives à la broche de raccordement 54, étant entendu que les opérations d'assemblage relatives à la broche de raccordement 55 sont similaires.

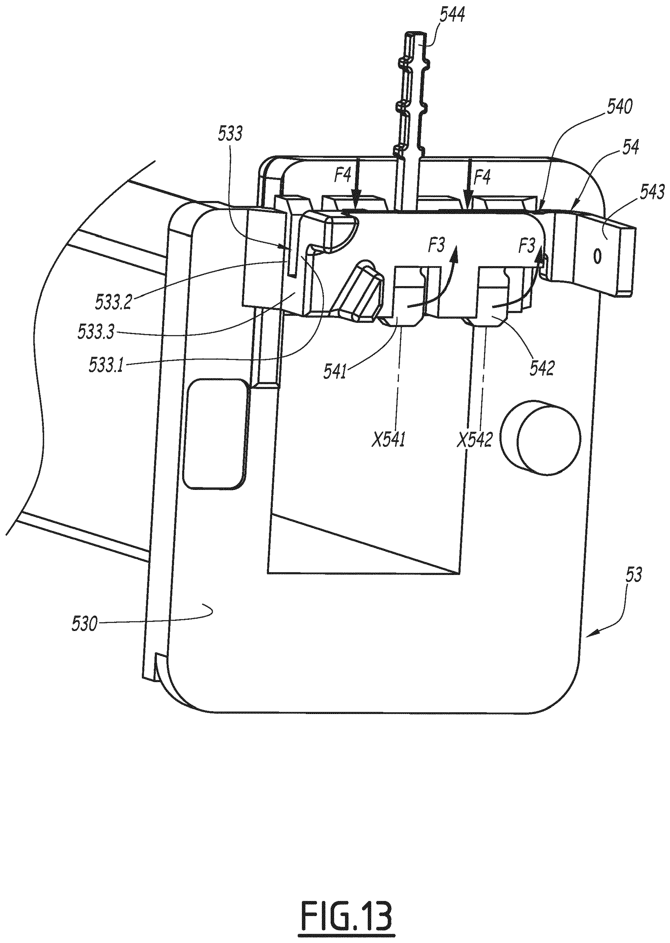

Initialement, c'est-à-dire avant l'assemblage effectif de la broche de raccordement 54 à la bobine 53, on dispose de la broche de raccordement 54 avec ses languettes 541 et 542 et son mât 544 dans un étant non-encore fléchi, comme illustré sur les figures 12 et 13. Les languettes 541 et 542 s'étendent alors, sur toute leur étendue depuis leur extrémité 541.1, 542.1 de jonction avec le corps principal 540, respectivement suivant les axes de languette X541 et X542. De même, le mât 544 s'étend, sur toute son étendue depuis son extrémité de jonction avec le corps principal 540, suivant une direction parallèle aux axes de languette X541 et X542.

La broche de raccordement 54 est alors rapportée sur la partie terminale 530 de la bobine 53, en étant introduite dans le logement 533 suivant une direction parallèle aux axes de languettes X541 et X542 et tournée vers l'axe de bobine X53, comme indiqué par la flèche F1 sur la figure 12. À cet effet, on utilise avantageusement un outillage qui est appliqué suivant la direction précitée contre les surfaces d'appui 540B.1 et 540B.2, comme indiqué par les flèches F2 sur la figure 12.

Une fois que la broche de raccordement 54 est introduite à fond dans le logement 533, les languettes 541 et 542 sont fléchies, comme indiqué par les flèches F3 sur la figure 13, de manière à plier les languettes 541 et 542 contre la paroi latérale 533.1 du logement 533 et ainsi aboutir à la conformation d'assemblage de ces languettes, décrite précédemment en lien avec les figures 7 à 11. À cet effet, on utilise un outillage de pliage ad hoc, le cas échéant partiellement introduit à l'intérieur de la bobine 53. Avantageusement, pendant l'opération de fléchissement des languettes 541 et 542, le corps principal 540 est maintenu en place dans le logement 533 en appliquant, suivant les axes de languette X541 et X542 un outillage ad hoc sur les surfaces d'appui 540B.1 et 540B.2, comme indiqué par les flèches F4 sur la figure 13.

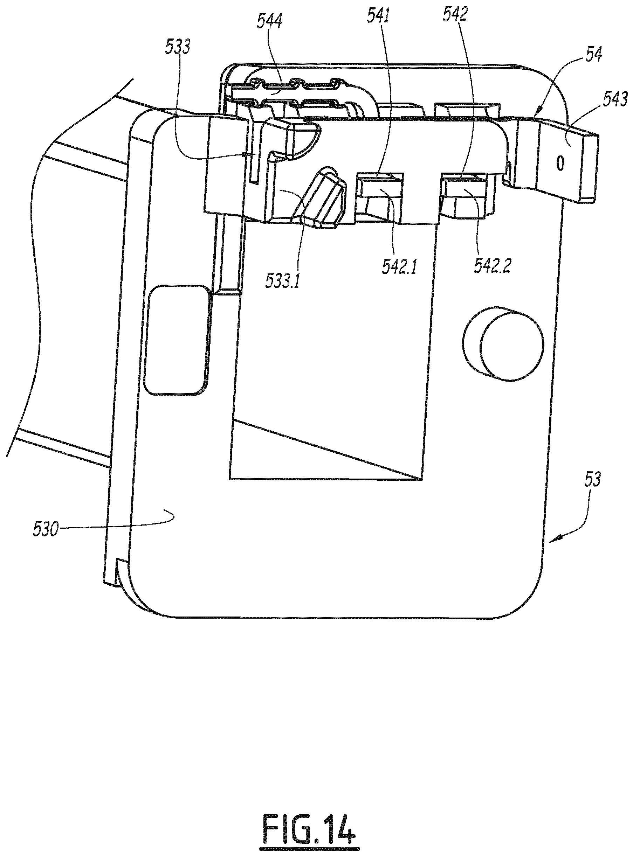

Pour passer ensuite de l'état d'assemblage illustré à la figure 13 à l'état d'assemblage illustré à la figure 14, les languettes 541 et 542 sont arasées au niveau de leur extrémité libre 541.2 et 542.2, afin de rendre ces extrémités libres 541.2 et 542.2 sensiblement affleurantes avec la paroi latérale 533.1 du logement 533, comme expliqué plus haut. De plus, le mât 544 est fléchi, avantageusement après avoir été assemblé à l'extrémité 521 du bobinage 52, comme expliqué plus haut.

À partir de l'état d'assemblage illustré à la figure 14, la piste électrique 56 peut être assemblée, notamment soudée, au bras 543, comme expliqué plus haut.

Enfin, divers aménagements et variantes au disjoncteur 1, au capteur de courant mixte 40, et au capteur magnétique de courant 50, décrits jusqu'ici, sont envisageables. Par exemple, les différentes variantes ayant été évoquées à différents endroits de la description ci-dessus peuvent être combinées entre elles, au moins de manière partielle.

## Revendications

1. Capteur magnétique de courant (50), comportant :
- un circuit magnétique (51) qui est conçu pour entourer un conducteur électrique (10) formant un circuit primaire pour le circuit magnétique,
- un bobinage (52) électrique, qui inclut deux extrémités (520, 521), ainsi qu'une partie courante (522) qui relie les deux extrémités et qui est enroulée autour d'une portion (511) du circuit magnétique (51),
- une bobine (53) isolante, qui définit un axe de bobine (X53) sur lequel la bobine est sensiblement centrée, et qui inclut deux parties terminales (530, 531) qui sont opposées l'une à l'autre suivant l'axe de bobine, la bobine étant radialement interposée entre ladite portion (511) du circuit magnétique (51), qui est reçue à l'intérieur de la bobine, et le bobinage (52), qui est bobiné coaxialement sur la bobine,
le capteur magnétique de courant (50) est **caractérisé en ce qu'**il comprend
- deux broches de raccordement (54, 55), qui sont respectivement montées sur les parties terminales (530, 531) de la bobine (53) et qui sont respectivement connectées aux extrémités (520, 521) du bobinage (52),
dans lequel chaque broche de raccordement (54, 55) inclut un corps principal (540, 550) qui est :
- reçu de manière complémentaire dans un logement (533, 534) ménagé dans la partie terminale correspondante (530, 531) de la bobine (53),
- allongé suivant un axe de corps (X540) s'étendant transversalement à l'axe de bobine (X53), et
- pourvu d'une première face latérale (540A), qui est tournée vers l'axe de bobine (X53), et d'une seconde face latérale (540B), qui est tournée à l'opposé de l'axe de bobine,
et dans lequel chaque broche de raccordement (54, 55) inclut également deux languettes (541, 542, 551, 552) qui :
- sont en saillie de la première face latérale (540A) du corps principal (540, 550), en courant chacune depuis une extrémité (541.1, 542.1) de jonction avec le corps principal jusqu'à une extrémité libre (541.2, 542.2),
- sont distantes l'une de l'autre suivant l'axe de corps (X540),
- à leur extrémité de jonction avec le corps principal, s'étendent depuis la première face latérale (540A) du corps principal suivant des axes de languette respectifs (X541, X542), qui sont parallèles et qui s'étendent chacun transversalement à l'axe de bobine (X53) et à l'axe de corps (X540), et
- entre leur extrémité de jonction avec le corps principal et leur extrémité libre, sont pliées contre une même paroi latérale (533.1) du logement correspondant (533, 534) de manière à retenir en position la broche de raccordement par rapport à la bobine (53).

2. Capteur magnétique de courant suivant la revendication 1, dans lequel chaque languette (541, 542, 551, 552) est pliée à 95° ± 5° contre la paroi latérale (533.1) du logement correspondant (533, 534).

3. Capteur magnétique de courant suivant l'une des revendications 1 ou 2, dans lequel les languettes (541, 542, 551, 552) de chaque broche de raccordement (54, 55) sont pliées de façon à se trouver en butée contre la paroi latérale (533.1) du logement correspondant (533, 534) suivant une direction parallèle aux axes de languette (X541, X542) de manière à empêcher de sortir du logement le corps principal (540, 550) suivant cette direction.

4. Capteur magnétique de courant suivant l'une quelconque des revendications précédentes, dans lequel les languettes (541, 542, 551, 552) de chaque broche de raccordement (54, 55) sont pliées de façon à se retrouver en butée contre la paroi latérale (533.1) du logement correspondant (533, 534) suivant des directions qui sont parallèles à l'axe de corps (X540) et opposées l'une à l'autre, de manière à immobiliser le corps principal (540, 550) dans le logement suivant ces directions.

5. Capteur magnétique de courant suivant l'une quelconque des revendications précédentes, dans lequel la première face latérale (540A) du corps principal (540, 550) de chaque broche de raccordement (54, 55) inclut des premières surfaces d'appui (540A.1, 540A.2, 540A.3) qui sont :
- situées de part et d'autre, suivant l'axe de corps (X540), d'au moins une des deux languettes (541, 542, 551, 552) de la broche de raccordement, et
- appuyées, suivant une direction parallèle aux axes de languette (X541, X542), contre une paroi de fond (533.3) du logement correspondant (533, 534).

6. Capteur magnétique de courant suivant l'une quelconque des revendications précédentes, dans lequel chaque languette (541, 542, 551, 552) de chaque broche de raccordement (54, 55) est, à son extrémité libre (541.2, 542.2), sensiblement en affleurement avec la paroi latérale (533.1) du logement correspondant (533, 534).

7. Capteur magnétique de courant suivant l'une quelconque des revendications précédentes, dans lequel les deux broches de raccordement (54, 55) sont symétriques l'une de l'autre par rapport à un plan géométrique (π) qui est perpendiculaire à l'axe de bobine (X53), sans pour autant être interchangeables l'une avec l'autre.

8. Capteur magnétique de courant suivant l'une quelconque des revendications précédentes, dans lequel le capteur magnétique de courant (50) comporte également deux pistes électriques (56, 57) qui relient respectivement les broches de raccordement (54, 55) à une charge de manière que le bobinage (52) puisse alimenter cette charge.

9. Capteur magnétique de courant suivant la revendication 8, dans lequel chaque broche de raccordement (54, 55) inclut en outre un bras (543, 553) qui :
- s'étend de manière coudée depuis une première des deux extrémités longitudinales (540.1, 540.2) du corps principal (540, 550), les languettes (541, 542, 551, 552) de la broche de raccordement et le bras étant tous fléchis vers un même côté latéral du corps principal, et
- est assemblé, notamment par soudure, à la piste électrique (56, 57) associée à la broche de raccordement, de manière à connecter cette piste électrique à la broche de raccordement.

10. Capteur magnétique de courant suivant la revendication 9, dans lequel chaque broche de raccordement (54, 55) ne se prolonge pas, suivant l'axe de corps (X540), depuis la seconde extrémité longitudinale (540.2) du corps principal (540, 550) à l'extérieur du logement correspondant (533, 534).

11. Capteur magnétique de courant suivant l'une des revendications 9 ou 10, dans lequel chaque broche de raccordement (54, 55) inclut en outre un mât (544, 554) :
- qui est en saillie de la seconde face latérale (540B) du corps principal (540, (550),
- qui est coudé vers la seconde extrémité longitudinale (540.2) du corps principal de manière à s'étendre le long de la seconde face latérale du corps principal, et
- autour duquel l'extrémité (520) du bobinage (52), associée à la broche de raccordement, est assemblée, notamment par soudure, de manière à connecter cette extrémité du bobinage à la broche de raccordement.

12. Capteur magnétique de courant suivant la revendication 11, dans lequel la seconde face latérale (540B) du corps principal (540, 550) de chaque broche de raccordement (54, 55) inclut des secondes surfaces d'appui (540B.1, 540B.2) qui sont :
- situées de part et d'autre, suivant l'axe de corps (X540), du mât (544, 554), et
- adaptées pour, avant fléchissement du mât, y appliquer un outillage d'insertion et/ou de maintien en place du corps principal dans le logement correspondant (533, 534), notamment pendant le fléchissement des languettes (541, 542, 551, 552).

13. Capteur de courant mixte (40), comportant :
- un capteur magnétique de courant (50), conforme à l'une quelconque des revendications 8 à 12,
- un dispositif de mesure de courant (60), comportant un bobinage de Rogowski (61), le circuit magnétique (51) du capteur magnétique de courant (50) et le bobinage de Rogowski (61) étant conçus pour entourer un même conducteur électrique (10) formant un circuit primaire pour chacun d'eux, et
- un circuit électronique (70), qui est configuré pour détecter et mesurer un courant électrique dans ledit conducteur électrique (10) à partir du courant circulant dans le bobinage de Rogowski (61), le circuit électronique (70) étant alimenté par le bobinage (52) du capteur magnétique de courant (50) en étant raccordé aux broches de raccordement (54, 55) par l'intermédiaire des pistes électriques (56, 57).

14. Disjoncteur (1), comportant un ou plusieurs pôles (P1, P2, P3, P4), ainsi qu'une enveloppe (2) isolante, qui supporte le ou les pôles,
dans lequel le ou chaque pôle (P1, P2, P3, P4) comporte :
- deux plots terminaux (10, 11), qui sont portés par l'enveloppe (2) et qui sont raccordables depuis l'extérieur de l'enveloppe à un circuit électrique à protéger par le disjoncteur (1),
- deux éléments de contact (20, 21), qui sont disposés dans une chambre de coupure (24) délimitée à l'intérieur de l'enveloppe (2), et qui sont respectivement raccordés aux plots terminaux (10, 11) tout en étant déplaçables l'un par rapport à l'autre entre une position fermée, dans laquelle les éléments de contact sont en contact direct l'un avec l'autre, et une position ouverte, dans laquelle les éléments de contact sont écartés l'un de l'autre,
- un capteur de courant mixte (40), qui est conforme à la revendication 13 et qui est agencé à l'intérieur de l'enveloppe (2) de manière que l'un des deux plots terminaux (10, 11) est entouré par à la fois le circuit magnétique (51) du capteur magnétique de courant (50) et le bobinage de Rogowski (61) du dispositif de mesure de courant (60) et forme ainsi un circuit primaire pour ce circuit magnétique et pour ce bobinage de Rogowski, et
- un mécanisme (30), qui est agencé à l'intérieur de l'enveloppe (2) et qui est adapté pour déplacer les éléments de contact (20, 21) de la position fermée vers la position ouverte lorsqu'une anomalie de fonctionnement est détectée par le circuit électronique (70) du capteur de courant mixte (40).

## Patentansprüche

1. Magnetischer Stromsensor (50), umfassend:
- einen Magnetkreis (51), der konzipiert ist, um einen elektrischen Leiter (10) zu umgeben, der einen Primärstromkreis für den Magnetkreis bildet,
- eine elektrische Spule (52), die zwei Enden (520, 521) sowie einen laufenden Teil (522) beinhaltet, der die zwei Enden verbindet und um einen Abschnitt (511) des Magnetkreises (51) gewickelt ist,
- eine isolierende Spule (53), die eine Spulenachse (X53) definiert, auf der die Spule im Wesentlichen zentriert ist, und die zwei Endabschnitte (530, 531) beinhaltet, die einander entlang der Spulenachse gegenüberliegen, die Spule radial zwischen dem Abschnitt (511) des Magnetkreises (51), der innerhalb der Spule aufgenommen ist, und der Spule (52), die koaxial auf die Spule gewickelt ist, angeordnet ist,
wobei der magnetische Stromsensor (50) **dadurch gekennzeichnet ist, dass** er Folgendes umfasst
- zwei Verbindungsstifte (54, 55), die jeweils an den Endabschnitten (530, 531) der Spule (53) montiert sind und die jeweils mit den Enden (520, 521) der Spule (52) verbunden sind, wobei jeder Verbindungsstift (54, 55) einen Hauptkörper (540, 550) beinhaltet, der:
- komplementär in einem Gehäuse (533, 534) aufgenommen ist, das in dem entsprechenden Endabschnitt (530, 531) der Spule (53) ausgebildet ist,
- länglich entlang einer Körperachse (X540) ist, die sich quer zu der Spulenachse (X53) erstreckt, und
- mit einer ersten Seitenfläche (540A), die der Spulenachse (X53) zugewandt ist, und einer zweiten Seitenfläche (540B), die von der Spulenachse abgewandt ist, versehen ist,
und wobei jeder Verbindungsstift (54, 55) auch zwei Laschen (541, 542, 551, 552) beinhaltet, die:
- von der ersten Seitenfläche (540A) des Hauptkörpers (540, 550) hervorstehen, wobei sie jeweils von einem Ende (541.1, 542.1) der Verbindung mit dem Hauptkörper zu einem freien Ende (541.2, 542.2) verlaufen,
- entlang der Körperachse (X540) voneinander beabstandet sind,
- sich an ihrem Verbindungsende mit dem Hauptkörper von der ersten Seitenfläche (540A) des Hauptkörpers entlang jeweiliger Laschenachsen (X541, X542) erstrecken, die parallel sind und sich jeweils quer zu der Spulenachse (X53) und zu der Körperachse (X540) erstrecken, und
- zwischen ihrem Verbindungsende mit dem Hauptkörper und ihrem freien Ende gegen eine gleiche Seitenwand (533.1) des entsprechenden Gehäuses (533, 534) gebogen sind, um den Verbindungsstift in Bezug auf die Spule (53) in Position zu halten.

2. Magnetischer Stromsensor nach Anspruch 1, wobei jede Lasche (541, 542, 551, 552) bei 95° ± 5° gegen die Seitenwand (533.1) des entsprechenden Gehäuses (533, 534) gebogen ist.

3. Magnetischer Stromsensor nach einem der Ansprüche 1 oder 2, wobei die Laschen (541, 542, 551, 552) von jedem Verbindungsstift (54, 55) gebogen sind, dass sie in einer Richtung parallel zu den Laschenachsen (X541, X542) an der Seitenwand (533.1) des entsprechenden Gehäuses (533, 534) anliegen, um zu verhindern, dass der Hauptkörper (540, 550) in dieser Richtung aus dem Gehäuse herausgezogen wird.

4. Magnetischer Stromsensor nach einem der vorherigen Ansprüche, wobei die Laschen (541, 542, 551, 552) von jedem Verbindungsstift (54, 55) gebogen sind, um in Richtungen, die parallel zu der Körperachse (X540) und entgegengesetzt zueinander sind, an der Seitenwand (533.1) des entsprechenden Gehäuses (533, 534) anzuliegen, um den Hauptkörper (540, 550) in diesen Richtungen in dem Gehäuse zu fixieren.

5. Magnetischer Stromsensor nach einem der vorherigen Ansprüche, wobei die erste Seitenfläche (540A) des Hauptkörpers (540, 550) von jedem Verbindungsstifts (54, 55) erste Anlageflächen (540A.1, 540A.2, 540A.3) beinhaltet, die:
- sich entlang der Körperachse (X540) auf beiden Seiten von mindestens einer der zwei Laschen (541, 542, 551, 552) des Verbindungsstifts befinden, und
- entlang einer Richtung parallel zu den Laschenachsen (X541, X542) an einer Bodenwand (533.3) des jeweiligen Gehäuses (533, 534) anliegen.

6. Magnetischer Stromsensor nach einem der vorherigen Ansprüche, wobei jede Lasche (541, 542, 551, 552) von jedem Verbindungsstift (54, 55) an ihrem freien Ende (541.2, 542.2) im Wesentlichen bündig mit der Seitenwand (533.1) dem entsprechenden Gehäuse (533, 534) ist.

7. Magnetischer Stromsensor nach einem der vorherigen Ansprüche, wobei die zwei Verbindungsstifte (54, 55) in Bezug auf eine geometrische Ebene (TT), die senkrecht zu der Spulenachse (X53) ist, symmetrisch zueinander sind, ohne dass sie untereinander austauschbar sind.

8. Magnetischer Stromsensor nach einem der vorherigen Ansprüche, wobei der magnetische Stromsensor (50) auch zwei elektrische Leiterbahnen (56, 57) umfasst, die die Verbindungsstifte (54, 55) jeweils mit einer Last verbinden, sodass die Spule (52) diese Last mit Strom versorgen kann.

9. Magnetischer Stromsensor nach Anspruch 8, wobei jeder Verbindungsstift (54, 55) ferner einen Arm (543, 553) beinhaltet, der:
- sich auf abgewinkelte Weise von einem ersten der zwei Längsenden (540.1, 540.2) des Hauptkörpers (540, 550) erstreckt, wobei die Laschen (541, 542, 551, 552) des Verbindungsstifts und der Arm alle zu einer gleichen seitlichen Seite des Hauptkörpers gebogen sind, und
- mit der elektrischen Leiterbahn (56, 57), die dem Verbindungsstift assoziiert ist, verbunden ist, insbesondere durch Schweißen, um diese elektrische Leiterbahn mit dem Verbindungsstift zu verbinden.

10. Magnetischer Stromsensor nach Anspruch 9, wobei sich nicht jeder Verbindungsstift (54, 55) entlang der Körperachse (X540) von dem zweiten Längsende (540.2) des Hauptkörpers (540, 550) aus dem entsprechenden Gehäuse (533, 534) nach außen erstreckt.

11. Magnetischer Stromsensor nach einem der Ansprüche 9 oder 10, wobei jeder Verbindungsstift (54, 55) ferner einen Mast (544, 554) beinhaltet:
- der von der zweiten Seitenfläche (540B) des Hauptkörpers (540, (550) hervorsteht,
- der zu dem zweiten Längsende (540.2) des Hauptkörpers hin abgewinkelt ist, um sich entlang der zweiten Seitenfläche des Hauptkörpers zu erstrecken, und
- um den herum das Ende (520) der Spule (52), das mit dem Verbindungsstift assoziiert ist, zusammengebaut wird, insbesondere durch Schweißen, um dieses Ende der Spule mit dem Verbindungsstift zu verbinden.

12. Magnetischer Stromsensor nach Anspruch 11, wobei die zweite Seitenfläche (540B) des Hauptkörpers (540, 550) von jedem Verbindungsstift (54, 55) zweite Anlageflächen (540B.1, 540B.2) beinhaltet, die:
- die sich entlang der Körperachse (X540) auf beiden Seiten des Mastes (544, 554) befinden, und
- geeignet sind, um vor dem Biegen des Masts ein Werkzeug zum Einsetzen und/oder Halten des Hauptkörpers in dem entsprechenden Gehäuse (533, 534) anzubringen, insbesondere während des Biegens der Laschen (541, 542, 551, 552).

13. Mischstromsensor (40), umfassend:
- einen magnetischen Stromsensor (50) nacheinem der Ansprüche 8 bis 12,
- eine Strommessvorrichtung (60), umfassend eine Rogowski-Spule (61), wobei der Magnetkreis (51) des magnetischen Stromsensors (50) und die Rogowski-Spule (61) konzipiert sind, um denselben elektrischen Leiter (10) zu umschließen, der für jeden davon einen Hauptstromkreis bildet, und
- eine elektronische Schaltung (70), die konfiguriert ist, um einen elektrischen Strom in dem elektrischen Leiter (10) anhand des in der Rogowski-Spule (61) fließenden Stroms zu erfassen und zu messen, wobei die elektronische Schaltung (70) von der Spule (52) des magnetischen Stromsensors (50) gespeist wird, indem sie über die elektrischen Leiterbahnen (56, 57) mit den Verbindungsstiften (54, 55) verbunden wird.

14. Schutzschalter (1), umfassend einen oder mehrere Pole (P1, P2, P3, P4) und einen isolierenden Mantel (2), der den einen oder die mehreren Pole trägt,
wobei der eine oder jeder Pol (P1, P2, P3, P4) Folgendes umfasst:
- zwei Endanschlüsse (10, 11), die von dem Mantel (2) getragen werden und von außerhalb des Mantels an einen Stromkreis anschließbar sind, der durch den Schutzschalter (1) geschützt werden soll,
- zwei Kontaktelemente (20, 21), die in einer im Inneren des Mantels (2) abgegrenzten Trennkammer (24) angeordnet sind und die jeweils mit den Endanschlüssen (10, 11) verbunden sind, während sie in Bezug aufeinander zwischen einer geschlossenen Position, in der die Kontaktelemente in direktem Kontakt miteinander sind, und einer offenen Position, in der die Kontaktelemente voneinander beabstandet sind, verschiebbar sind,
- einen Mischstromsensor (40) nach Anspruch 13 und der innerhalb des Mantels (2) angeordnet ist, sodass einer der zwei Endanschlüsse (10, 11) sowohl von dem Magnetkreis (51) des magnetischen Stromsensors (50) als auch von der Rogowski-Spule (61) der Strommessvorrichtung (60) umgeben ist und somit einen Hauptstromkreis für diesen Magnetkreis und für diese Rogowski-Spule bildet, und
- einen Mechanismus (30), der im Innern des Mantels (2) angeordnet und angepasst ist, um die Kontaktelemente (20, 21) von der geschlossenen Position in die offene Position zu bewegen, wenn eine Betriebsstörung von der elektronischen Schaltung (70) des Mischstromsensors (40) erkannt wird.

## Claims

1. A magnetic current sensor (50), comprising:
- a magnetic circuit (51) which is designed to surround an electrical conductor (10) forming a primary circuit for the magnetic circuit,
- an electrical winding (52), which includes two ends (520, 521), as well as a running part (522) which connects the two ends and which is wound around a portion (511) of the magnetic circuit (51),
- an insulating coil (53), which defines a coil axis (X53) on which the coil is substantially centred, and which includes two end parts (530, 531) which are opposite each other along the coil axis, the coil being radially interposed between said portion (511) of the magnetic circuit (51), which is received within the coil, and the winding (52), which is coaxially wound on the coil,
the magnetic current sensor (50) is **characterised in that** it comprises
- two connection pins (54, 55), which are respectively mounted on the end parts (530, 531) of the coil (53) and which are respectively connected to the ends (520, 521) of the winding (52),
wherein each connection pin (54, 55) includes a main body (540, 550) which is:
- received in a complementary manner in a housing (533, 534) provided in the corresponding end part (530, 531) of the coil (53),
- elongated along a body axis (X540) extending transversely to the coil axis (X53), and
- provided with a first side face (540A), which faces towards the coil axis (X53), and a second side face (540B), which faces away from the coil axis,
and wherein each connection pin (54, 55) also includes two tabs (541, 542, 551, 552) which:
- project from the first side face (540A) of the main body (540, 550), each running from an end (541.1, 542.1) where it joins the main body to a free end (541.2, 542.2),
- are spaced apart along the body axis (X540),
- at their junction end with the main body, extend from the first side face (540A) of the main body along respective tab axes (X541, X542), which are parallel and each extend transversely to the coil axis (X53) and the body axis (X540), and
- between their junction end with the main body and their free end, are folded against the same side wall (533.1) of the corresponding housing (533, 534) so as to hold the connection pin in position relative to the coil (53).

2. The magnetic current sensor according to claim 1, wherein each tab (541, 542, 551, 552) is bent at 95° ± 5° against the side wall (533.1) of the corresponding housing (533, 534).

3. The magnetic current sensor according to one of claims 1 or 2, wherein the tabs (541, 542, 551, 552) of each connection pin (54, 55) are bent so as to abut the side wall (533.1) of the corresponding housing (533, 534) in a direction parallel to the tab axes (X541, X542) so as to prevent the main body (540, 550) from coming out of the housing in that direction.

4. The magnetic current sensor according to any one of the preceding claims, wherein the tabs (541, 542, 551, 552) of each connection pin (54, 55) are bent so as to abut against the side wall (533.1) of the corresponding housing (533, 534) in directions which are parallel to the body axis (X540) and opposite each other, so as to immobilise the main body (540, 550) in the housing in these directions.

5. The magnetic current sensor according to any one of the preceding claims, wherein the first side face (540A) of the main body (540, 550) of each connection pin (54, 55) includes first bearing surfaces (540A.1, 540A.2, 540A.3) which are:
- located on either side, along the body axis (X540), of at least one of the two tabs (541, 542, 551, 552) of the connection pin, and
- pressed, in a direction parallel to the tab axes (X541, X542), against a bottom wall (533.3) of the corresponding housing (533, 534).

6. The magnetic current sensor according to any one of the preceding claims, wherein each tab (541, 542, 551, 552) of each connection pin (54, 55) is, at its free end (541.2, 542.2), substantially flush with the side wall (533.1) of the corresponding housing (533, 534).

7. The magnetic current sensor according to any one of the preceding claims, wherein the two connection pins (54, 55) are symmetrical to each other with respect to a geometric plane (TT) which is perpendicular to the coil axis (X53), without however being interchangeable with each other.

8. The magnetic current sensor according to any one of the preceding claims, wherein the magnetic current sensor (50) further comprises two electrical tracks (56, 57) which respectively connect the connection pins (54, 55) to a load so that the winding (52) can supply this load.

9. The magnetic current sensor according to claim 8, wherein each connection pin (54, 55) further includes an arm (543, 553) which:
- extends at an angle from a first of the two longitudinal ends (540.1, 540.2) of the main body (540, 550), the tabs (541, 542, 551, 552) of the connection pin, and the arm all being bent towards the same lateral side of the main body, and
- is assembled, in particular by welding, to the electrical track (56, 57) associated with the connection pin, so as to connect this electrical track to the connection pin.

10. The magnetic current sensor according to claim 9, wherein each connection pin (54, 55) does not extend, along the body axis (X540), from the second longitudinal end (540.2) of the main body (540, 550) outside the corresponding housing (533, 534).

11. The magnetic current sensor according to any one of claims 9 or 10, wherein each connection pin (54, 55) further includes a mast (544, 554):
- which projects from the second side face (540B) of the main body (540, (550),
- which is angled towards the second longitudinal end (540.2) of the main body so as to extend along the second side face of the main body, and
- around which the end (520) of the winding (52), associated with the connection pin, is assembled, in particular by welding, so as to connect this end of the winding to the connection pin.

12. The magnetic current sensor according to claim 11, wherein the second side face (540B) of the main body (540, 550) of each connection pin (54, 55) includes second bearing surfaces (540B.1, 540B.2) which are:
- located on either side, along the body axis (X540), of the mast (544, 554), and
- adapted, before the mast is bent, to apply a tool for inserting and/or holding the main body in place in the corresponding housing (533, 534), in particular during the bending of the tabs (541, 542, 551, 552).

13. A mixed current sensor (40), comprising:
- a magnetic current sensor (50) according to any one of claims 8 to 12,
- a current measuring device (60), comprising a Rogowski coil (61), the magnetic circuit (51) of the magnetic current sensor (50) and the Rogowski coil (61) being designed to surround the same electrical conductor (10) forming a primary circuit for each of them, and
- an electronic circuit (70), which is configured to detect and measure an electric current in said electric conductor (10) from the current flowing in the Rogowski coil (61), the electronic circuit (70) being powered by the winding (52) of the magnetic current sensor (50) by being connected to the connection pins (54, 55) via the electrical tracks (56, 57).

14. A circuit breaker (1), comprising one or more poles (P1, P2, P3, P4), as well as an insulating enclosure (2), which supports the pole or poles,
wherein the or each pole (P1, P2, P3, P4) comprises:
- two terminal studs (10, 11), which are supported by the enclosure (2) and can be connected from outside the enclosure to an electrical circuit to be protected by the circuit breaker (1),
- two contact elements (20, 21), which are arranged in a disconnection chamber (24) delimited inside the enclosure (2), and which are respectively connected to the terminal studs (10, 11) while being movable relative to each other between a closed position, wherein the contact elements are in direct contact with each other, and an open position, wherein the contact elements are moved away from each other,
- a mixed current sensor (40), which is according to claim 13 and which is arranged inside the enclosure (2) in such a way that one of the two terminal studs (10, 11) is surrounded by both the magnetic circuit (51) of the magnetic current sensor (50) and the Rogowski coil (61) of the current measuring device (60) and thus forms a primary circuit for this magnetic circuit and for this Rogowski coil, and
- a mechanism (30), which is arranged inside the enclosure (2) and which is adapted to move the contact elements (20, 21) from the closed position to the open position when an operating anomaly is detected by the electronic circuit (70) of the mixed current sensor (40).
